# EUROPEAN PATENT SPECIFICATION

(11) **EP 2 713 459 B1**
(45) Date of publication and mention of the grant of the patent: **21.06.2017**
(21) Application number: 12008301.9
(22) Date of filing: 12.12.2012
(51) Int. Cl.: H02B 1/50

(54) **Installation element for a street cabinet**
Installationselement für einen Strassenschrank
Élément d'installation pour une armoire de rue

(30) Priority: 26.09.2012 GB 201217196; 06.11.2012 GB 201219997
(43) Date of publication of application: 02.04.2014
(73) Proprietor: Permashutter Limited, Northamptonshire NN2 6JD (GB)
(72) Inventor: Willis, Steve Jeffrey, Northampton, Northamptonshire NN2 6JD (GB)
(74) Representative: Franks & Co (South) Limited

(56) References cited:
- EP-A1- 1 047 167
- GB-A- 2 479 607
- US-A- 5 373 956

## Description

### Field of the Invention

The present invention relates to the installation of ground-mounted articles of street furniture, in particular to an installation element for use in a method of installation of a ground-mounted article of street furniture, and a method of installation of a ground-mounted article of street furniture.

### Background of the Invention

The term 'street furniture' includes a variety of articles installed on or by roads, pavements, railway lines and canals, for example: street lights, traffic lights, bollards, benches, electrical cabinets and telecommunications cabinets.

Electrical and telecommunications cabinets are equipment enclosures typically provided for housing circuit connections and components, for example: wires, cables, switches, junctions, routers, repeaters, amplifiers and other electrical and electronic devices. These types of cabinets are located wherever electrical or telecommunications services are required, and are ground-mounted at an appropriate site. Typically, the installation of such a cabinet involves casting a concrete base within a hole in the ground that will support the cabinet. Document GB2479607 discloses a plastic mould forming a base for a cabinet, the base further comprising a sealing element. A problem exists in ensuring that the concrete base is able to accommodate cabling passing from the ground into the cabinet at an appropriate point of entry.

### Summary of the Invention

According to a first aspect of the present invention, there is provided an installation element for use in a method of installation of a ground-mounted article of street furniture, said installation element comprising: an underside for location upon a support base for an article of ground-mounted street furniture, and an upper side comprising a gasket-receiving region defined by a base surface from which an inner side wall and an outer side wall extend upwardly, said gasket-receiving region for receiving a rubber gasket therein upon which the lower edges of the article of ground-mounted street furniture can be located, said installation element comprising a central region internally of said inner side wall of said gasket-receiving region and a perimeter flange externally of said outer side wall gasket-receiving region, said central region defining at least one aperture therethrough, open to said upper side and to said underside, for receiving a utility item therein.

According to a second aspect of the present invention, there is provided a method of installation of a ground-mounted article of street furniture, said method comprising the steps of: receiving an installation element according to the first aspect, positioning said received installation element at a ground installation site, and using said positioned installation element as a template for establishing a support base location for said ground-mounted article of street furniture.

The method of the second aspect may comprise the further steps of: excavating a support base hole at said support base location, positioning said installation element in the excavated support base hole, and using said positioned installation element as a template for establishing a utility item location for said ground-mounted article of street furniture.

The method of the second aspect may comprise the yet further steps of: removing said positioned installation element from said excavated support base hole, filling said excavated support base hole with support base material to form a support base for said ground-mounted article of street furniture, and siting said installation element upon said support base.

### Brief Description of the Drawings

For a better understanding of the invention and to show how the same may be carried into effect, there will now be described by way of example only, specific embodiments, methods and processes according to the present invention with reference to the accompanying drawings in which:
*Figure 1* shows an installation element in use at an installation site for a ground-mounted article of street furniture;
*Figure 2* shows the installation element of *Figure 1* in further detail;
*Figure 3* shows further views of the installation element of *Figures 1* and *2**,*
*Figure 4* shows a schematic of the scenario shown in *Figure 1*; and
*Figures 5* to *10* show use of the installation element of *Figures 1* to *3*, in a method of installation of a ground-mounted article of street furniture

### Detailed Description of the Embodiments

There will now be described by way of example a specific mode contemplated by the inventor. In the following description numerous specific details are set forth in order to provide a thorough understanding. It will be apparent however, to one skilled in the art, that the present invention may be practiced without limitation to these specific details. In other instances, well known methods and structures are not described in detail so as not to unnecessarily obscure the description.

### Figure 1

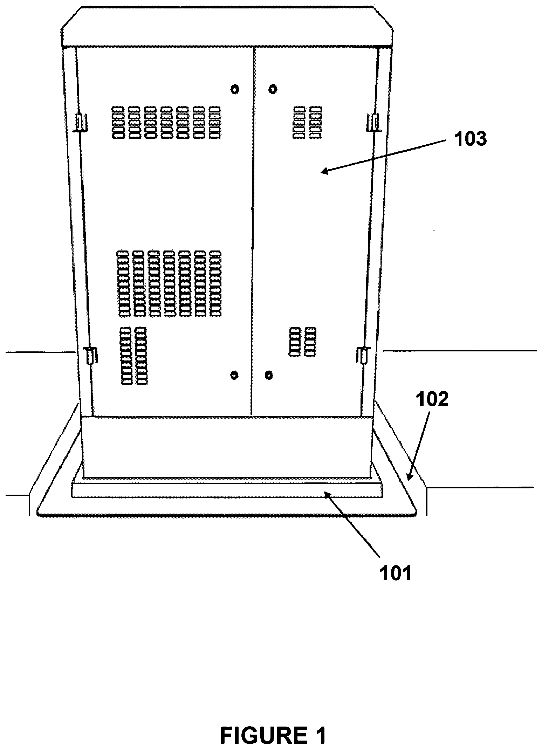

An installation element 101 is shown in use in Figure 1, at an installation site 102 for a ground-mounted article of street furniture 103. In this illustrated scenario, the ground-mounted article of street furniture 103 is a telecommunications cabinet, but may be an electrical cabinet or other article of street furniture.

Installation element 101 provides a physical interface between an installed ground-mounted article of street furniture and the ground of the installation site, from which cabling may extend into the installed article of street furniture. As will be described, the installation element 101 is provided for use in a method of installation of a ground-mounted article of street furniture. A method of installation of a ground-mounted article of street furniture will also be described.

### Figure 2

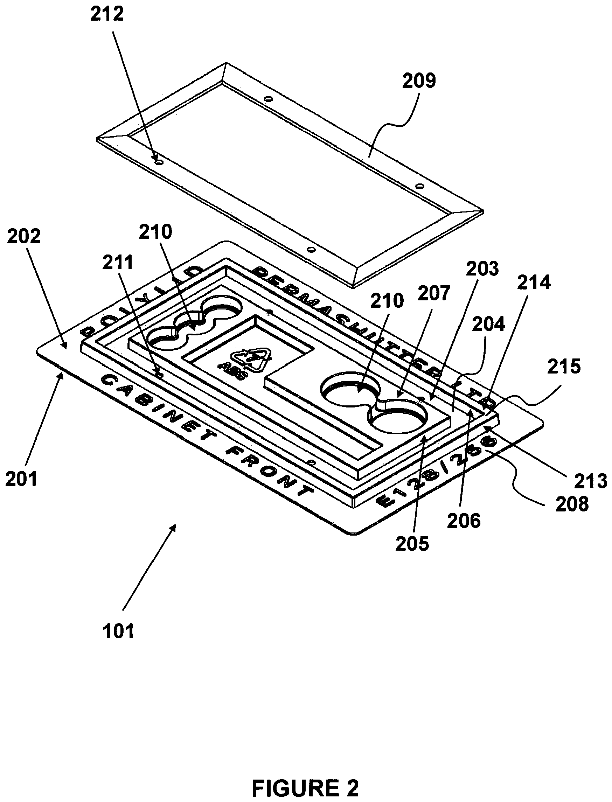

Figure 2 shows installation element 101 in further detail. The installation element 101 comprises an underside 201, for location upon a support base for an article of ground-mounted street furniture, and an upper side 202. The upper side 202 of the installation element 101 comprises a gasket-receiving region 203 defined by a base surface 204 from which an inner side wall 205 and an outer side wall 206 extend upwardly.

The installation element 101 comprises a central region 207 internally of the inner side wall 205 of the gasket-receiving region 203 and a perimeter flange 208 externally of the outer side wall 206 of the gasket-receiving region 203. The gasket-receiving region 203 is configured to receive a rubber gasket 209 therein, upon which the base edges of an article of ground-mounted street furniture can be located. The rubber gasket 209 is dimensioned to so fit within the gasket-receiving region 203 as to be able to provide a water-tight seal between the edges of a ground-mounted article of street furniture received thereon and the installation element 101.

The central region 207 of the installation element 101 defines at least one aperture 210 therethrough, open to the upper side 202 and to the underside 201 of the installation element 101, for receiving a utility item therein.

The installation element 101 also defines at least one aperture 211 therethrough, for receiving a mechanical fixing therein, the mechanical fixing for connecting a ground-mounted article of street furniture to the installation element 101. In this embodiment, the base surface 204 of the gasket-receiving region 203 defines the at least one aperture 211 therethrough. Preferably, and as shown, the rubber gasket 209 to be located within the gasket-receiving region 203 of the installation element 101 defines a corresponding at least one aperture 212 therethrough, for receiving a mechanical fixing therein.

In this embodiment, the perimeter flange 208 extends outwardly from an outer wall 213 of the installation element 101. As shown, the installation element 101 presents a raised perimeter 214 around the gasket-receiving region 203. In the illustrated arrangement, the raised perimeter 214 is formed by the outer side wall 206 of the gasket-receiving region 203, the outer wall 213 and a connecting wall 215.

### Figure 3

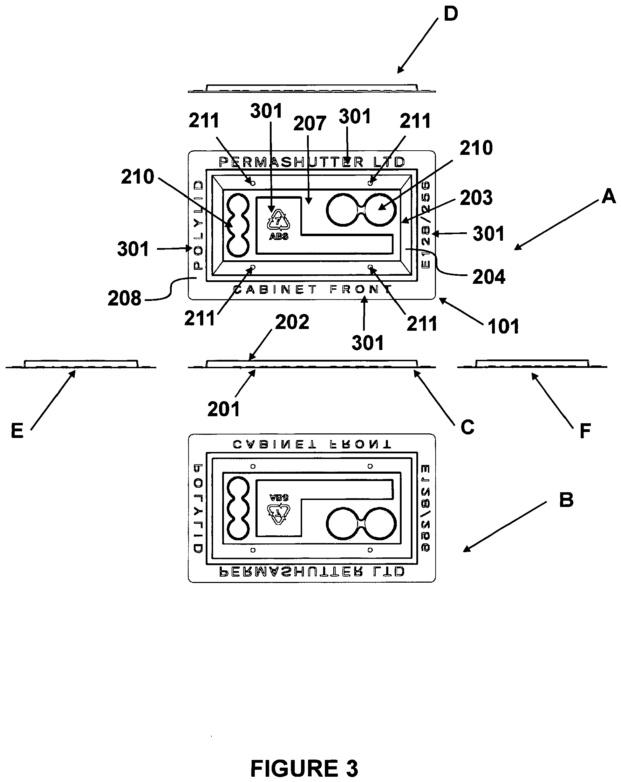

Different views of installation element 101 are shown in Figure 3. A top view is shown at A, a bottom view is shown at B, a front side view is shown at C, a rear side view is shown at D, a left side view is shown at E and a right side view is shown at F. Further details of this illustrated embodiment will now be described.

The overall shape of the installation element 101 is substantially rectangular, but may have any other suitable shape. The gasket-receiving region 203 also has a substantially rectangular-frame shape, but again may have any other suitable shape. It is to be appreciated that the shape and dimensions of the installation element and gasket-receiving region thereof may vary according to the shape and dimension of a particular article of ground-mounted street furniture with which the installation element 101 is to be used.

The underside 201 of the installation element 101 has a substantially planar profile. The perimeter flange 208 extends in substantially the same plane as the base surface 204 of the gasket-receiving region 203. The perimeter flange 208 has a substantially rectangular-frame shape, but may have any other suitable shape, and may have any suitable dimensions.

The central region 207 of the installation element 101 defines a pair of apertures 210 that are each configured to receive a plurality of utility items therein. A different number of these apertures may however be provided, in any suitable arrangement. Each of these apertures may be configured to receive the same, or a different number, of cabling items as another of the apertures, and an aperture may be configured to receive only a single utility item. It is to be appreciated that the number and arrangement of apertures 210 defined in the central region 207 of the installation element 101 may vary according to a particular article of ground-mounted street furniture with which the installation element 101 is to be used.

An aperture 210 defined in the central region 207 may have any suitable shape and dimensions. The utility item may be: a cable, a cable duct or earth rod. It is to be appreciated that other items may be inserted through an aperture defined in the central region 207 of the installation element 101. Further, an aperture defined in the central region 207 of the installation element 101 may be provided with a user removable infill piece for example a press-out infill piece.

In this embodiment, the base surface 204 of the gasket-receiving region 203 defines a pair of apertures 211 that are spaced apart on each long side of the substantially rectangular-frame shape thereof, each for receiving a mechanical fixing therein. One or more of these apertures 211 may also be provided on each short side of the substantially rectangular-frame shape of the gasket-receiving region 203. Any suitable number of these apertures 211 may be provided, in any suitable arrangement.

The installation element 101 may be fabricated from any suitable material or combination of materials, and may be manufactured using any suitable process or combination of processes. In an embodiment, the installation element is fabricated from a plastics material, and is manufactured using: a vacuum forming process, an injection moulding process or a rotational moulding process. In a specific embodiment, the installation element is fabricated from acrylonitrile butadiene styrene (ABS) plastic.

In this embodiment, the installation element 101 presents informative indicia. In this example, the perimeter flange 208 of the installation element 101 presents items of indicia 301 along each edge of the substantially rectangular-frame shape thereof. In this example, the central region 207 of the installation element 101 also presents an item of indicia 301. Further, in the shown arrangement, the installation element 101 presents at least one item of informative indicia that is readable when viewed from the upper side 202 thereof, but may alternatively or additionally present at least one item of informative indicia that is readable when viewed from the underside 201 thereof. An item of indicia 301 may be applied to or formed in the installation element 101 by any suitable technique.

The installation element 101 may also have any suitable colouration, to contrast with, or complement, the environment in which it is to be used.

### Figure 4

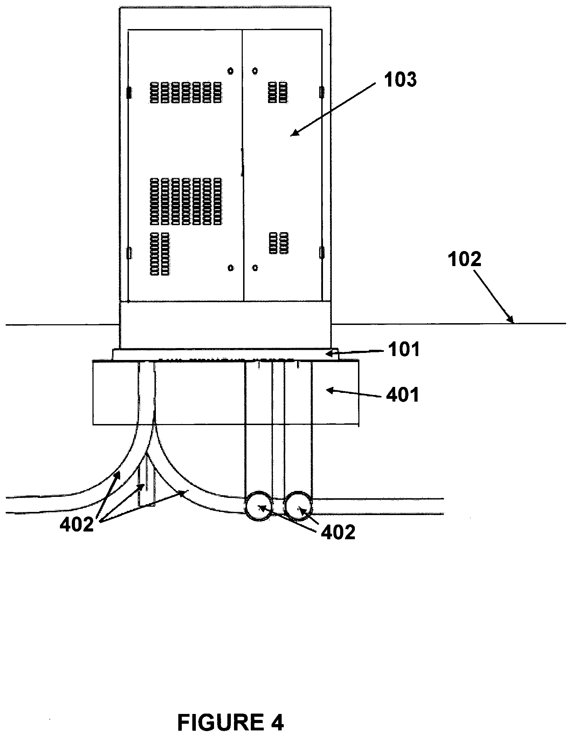

Figure 4 shows a schematic of the scenario illustrated in Figure 1. At the installation site 102, the installation element 101 is located upon a support base 401 for the telecommunications cabinet 103, between the support base 401 and the telecommunications cabinet 103. As shown, utility items 402 extend through the support base 401 and into the telecommunications cabinet 103.

A problem experienced with the installation of the telecommunications cabinet 103 is ensuring that each utility item that is to extend into the telecommunications cabinet 103 passes through, and exits, the support base at an appropriate location for entry into the telecommunications cabinet 103.

### Figures 5 to 10

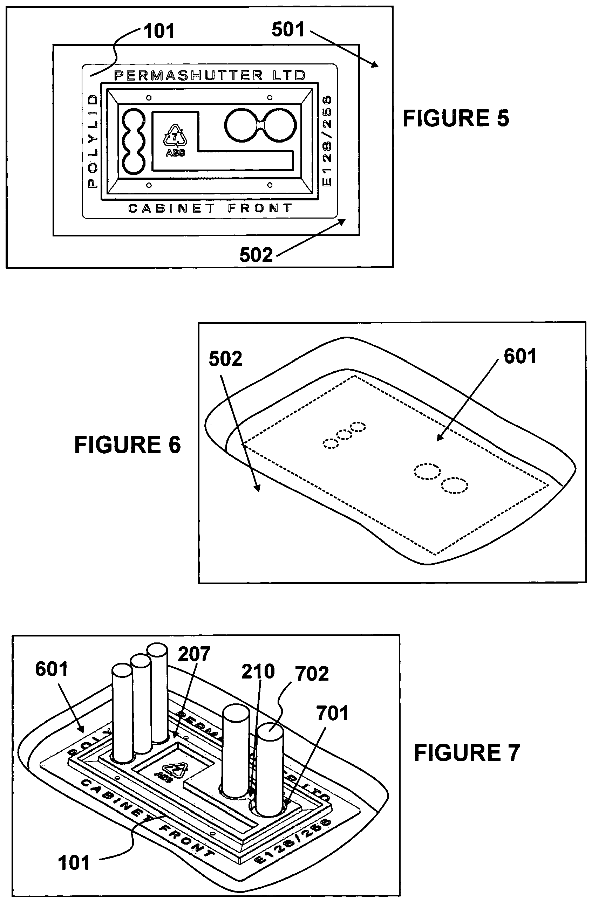

Figures 5 to 10 illustrate steps in a method of installation of a ground-mounted article of street furniture.

As shown in Figure 5, an installation element 101 is received and positioned at a ground installation site 501. The installation element 101 may at this step be simply placed upon the ground. The positioned installation element 101 is then used as a template for establishing a support base location 502 for a ground-mounted article of street furniture. Any suitable type of marker or ground-indentation tool may be used at this step.

The support base location 502 defines where a support base hole is to be excavated, for subsequent filling with support base material to form a support base for the ground-mounted article of street furniture.

The provision of the installation element 101 as a template for use in establishing the footprint of the support base location 502 serves to ensure that a support base hole of the correct width and length is excavated. Instructions for use of the installation element 101 at this step may specify that a support base footprint that extends a predetermined distance around the installation element 101 must be established. For example, installation instructions may state that the size of the support base footprint must be at least 20mm greater than the footprint of the installation element 101, all around the installation element 101.

The installation element 101 is then removed and, as shown in Figure 6, a support base hole 601 is excavated at the support base location 502. The support base hole 601 may be excavated by using any suitable tool. As previously discussed, the support base hole 601 should have a length and width that is greater than the length and width of the installation element and should also have an appropriate depth for forming a suitable base for the ground-mounted article of street furniture to be installed therein.

As illustrated in Figure 7, the installation element 101 is then positioned in the excavated support base hole 601 and the positioned installation element 101 is used as a template for checking a utility item location 701 for a utility item 702 for the ground-mounted article of street furniture. At this step, the apertures 210 defined with the central region 207 of the installation element 101 conveniently indicate a correct utility item location. This facilitates alignment of the utility items 702 within the support base hole 601 prior to the support base for the ground-mounted article of street furniture being formed.

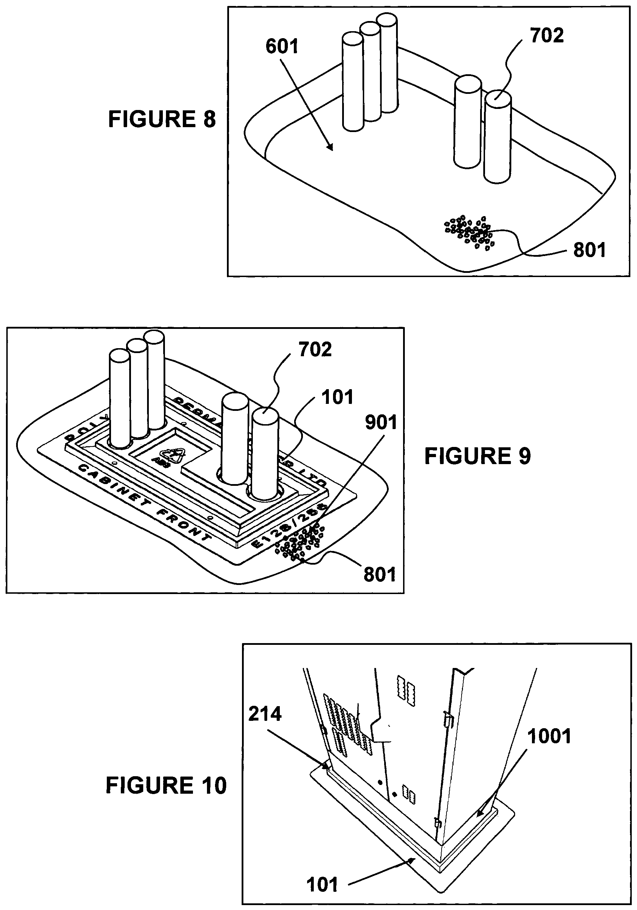

The installation element 101 is then removed from the excavated support base hole 601 and, as shown in Figure 8, the excavated support base hole 601 is filled with support base material 801 to form a support base for the ground-mounted article of street furniture. It can be seen in this Figure the utility items 702 shown in Figure 7 remain sited, with the support base material 801 being filled around them. The installation element is thus used as described with reference to Figure 7 to ensure that the utility items are correctly located before proceeding to form the support base. The support base material may comprise one or more of: concrete, stone, sand, earth, aggregate material and spoil from the excavation of the support base hole. It is to be appreciated that the support base may be formed from different layers of material or different materials.

As shown in Figure 9, the installation element 101 is then sited upon the support base 901 formed by the support base material 801. The installation element 101 is located over, and to receive, the utility items 702.

With reference to the steps of Figures 8 and 9, in a specific method, the installation element 101 is located upon a support base comprising concrete before the concrete has cured. The underside of the installation element 101 is arranged in direct contact with the support base material, and is cured therein. Prior to this step, a rubber gasket is located within the gasket-receiving region of the installation element at an appropriate stage, and mechanical fixings for securing the ground-mounted article of street furniture to the installation element are located within the apertures defined for this purpose as previously described. When the concrete has cured, the installation element is cleaned, and a suitable sealant is used to create a seal between received utility items and the installation element. It is to be appreciated that installation steps other than those specifically outlined with reference to Figures 5 to 9 may be performed at an appropriate stage in the method of installation of a ground-mounted article of street furniture.

As shown in Figure 10, when final preparations have been completed, the ground-mounted article of street furniture 1001 is located upon installation element 101. The lower edges of the ground-mounted article of street furniture 1001 are received within the gasket-receiving region of the installation element 101 and upon the rubber gasket located within the gasket-receiving region.

The raised perimeter 214 that extends around the gasket-receiving region of the installation element 101 provides a visual and physical guide for alignment of the ground-mounted article of street furniture 1001 as it is being lowered onto the installation element 101. In particular, the raised perimeter 214 facilitates alignment of the lower edges of the ground-mounted article of street furniture 1001 relative to the gasket-receiving region of the installation element and the mechanical fixings for securing the ground-mounted article of street furniture to the installation element thereupon.

It is to be appreciated that the lower edges of the ground-mounted article of street furniture located upon the installation element may be the lower edges of the ground-mounted article of street furniture itself and or, alternatively, the lower edges of a platform element (known as a 'root') at the bottom of the ground-mounted article of street furniture that is provided for the purpose of raising the ground-mounted article of street furniture above the ground.

Final steps to complete the installation may then be performed. Support base material and/or ground material at the installation site may be allowed to extend over the perimeter flange of the installation element following installation. This may be desirable, for example, to blend the installation element into the ground installation site.

The installation element described herein provides a physical interface between a ground-mounted article of street furniture and the support base for the ground-mounted article of street furniture, and advantageously provides a template for use in the establishment of the correct footprint for the support base location, and the correct location of utility items for entry into the ground-mounted article of street furniture being installed. The installation element described herein beneficially improves the accuracy and the speed of installation of utility items for a ground-mounted article of street furniture and the ground-mounted article of street furniture. The installation element described provides an improved method of installation of a ground-mounted article of street furniture.

## Claims

1. An installation element (101) for use in a method of installation of a ground-mounted article of street furniture (103), such as a cabinet, said installation element (101) comprising:
an underside (201) for location upon a support base (401,901) for an article of ground-mounted street furniture (103), and
an upper side (202) comprising a gasket-receiving region (203) defined by a base surface (204) from which an inner side wall (205) and an outer side wall (206) extend upwardly, said gasket-receiving region (203) for receiving a rubber gasket (209) therein upon which the lower edges of the article of ground-mounted street furniture (103) can be located,
said installation element (101) comprising a central region (207) internally of said inner side wall (205) of said gasket-receiving region (203) and a perimeter flange (208) externally of said outer side wall (206) of said gasket-receiving region (203)
said central region (207) defining at least one aperture (210) therethrough, open to said upper side (202) and to said underside (201), for receiving a utility item (702) therein,
***characterised in that***
said perimeter flange (208) extends substantially in the same plane as said base surface (204) of said gasket-receiving region (203).

2. An installation element (101) as claimed in claim 1, wherein said base surface (204) of said gasket-receiving region (203) defines at least one aperture (211) therethrough for receiving a mechanical fixing therein.

3. An installation element (101) as claimed in either claim 1 or claim 2, having a substantially rectangular shape.

4. An installation element (101) as claimed in any preceding claim, wherein said gasket-receiving region (203) has a substantially rectangular-frame shape.

5. An installation element (101) as claimed in any preceding claim, fabricated from a plastics material.

6. An installation element (101) as claimed in claim 5, manufactured using one of: a vacuum forming process, an injection moulding process, a rotational moulding process.

7. An installation element (101) as claimed in any preceding claim, wherein said central region (207) defines a plurality of apertures (210) that are each configured to receive more than one utility item (702) therein.

8. An installation element (101) as claimed in any preceding claim, wherein said utility item (702) is: a cable, a cable duct, an earth rod.

9. An installation element (101) as claimed in any preceding claim, for: an electrical cabinet, a telecommunications cabinet.

10. A method of installation of a ground-mounted article of street furniture (103), said method comprising the steps of:
receiving an installation element (101) as claimed in any of claims 1 to 9,
positioning said received installation element (101) at a ground installation site (501), and
using said positioned installation element (101) as a template for establishing a support base location (502) for said ground-mounted article of street furniture (103).

11. A method as claimed in claim 10, comprising the further steps of:
excavating a support base hole (601) at said support base location (502),
positioning said installation element (101) in the excavated support base hole (601), and
using said positioned installation element (101) as a template for establishing a utility item location (701) for said ground-mounted article of street furniture (103).

12. A method as claimed in claim 11, comprising the further steps of:
removing said positioned installation element (101) from said excavated support base hole (601),
filling said excavated support base hole (601) with support base material (801) to form a support base (901) for said ground-mounted article of street furniture (103), and
siting said installation element (101) upon said support base (901).

13. A method as claimed in claim 12, comprising the further steps of:
receiving a rubber gasket (209) for use with said installation element (101), and
locating said received rubber gasket (209) within said gasket-receiving region (203) of said sited installation element (101).

14. A method as claimed in claim 13, comprising the further steps of:
receiving said ground-mounted article of street furniture (103), and
locating said received ground-mounted article of street furniture (103) upon said rubber gasket (209) located with said gasket-receiving region (203) of said sited installation element (101).

## Patentansprüche

1. Installationselement (101) zur Verwendung in einem Verfahren zum Installieren eines am Boden montierten Artikels von Stadtmöblierung (103), wie etwa eines Schranks, wobei das Installationselement (101) Folgendes umfasst:
eine Unterseite (201) zum Platzieren auf einer Stützbasis (401, 901) für einen Artikel von am Boden montierter Stadtmöblierung (103) und
eine Oberseite (202), umfassend einen eine Dichtung aufnehmenden Bereich (203), der durch eine Basisoberfläche (204), von der sich eine innere Seitenwand (205) und eine äußere Seitenwand (206) aus nach oben erstrecken, definiert ist, wobei der die Dichtung aufnehmende Bereich (203) zum Aufnehmen einer Gummidichtung (209) darin, auf der die unteren Kanten des Artikels von am Boden montierter Stadtmöblierung (103) platziert sein können, vorgesehen ist,
wobei das Installationselement (101) einen Mittelbereich (207) innerhalb der inneren Seitenwand (205) des die Dichtung aufnehmenden Bereichs (203) und einen Umfangsflansch (208) außerhalb der äußeren Seitenwand (206) des die Dichtung aufnehmenden Bereichs (203) umfasst,
wobei der Mittelbereich (207) wenigstens eine Öffnung (210) dahindurch definiert, die zur Oberseite (202) und zur Unterseite (201) hin offen ist, um einen Versorgungsgegenstand (702) darin aufzunehmen,
***dadurch gekennzeichnet, dass***
der Umfangsflansch (208) sich im Wesentlichen in der gleichen Ebene erstreckt wie die Basisoberfläche (204) des die Dichtung aufnehmenden Bereichs (203).

2. Installationselement (101) nach Anspruch 1, wobei die Basisoberfläche (204) des die Dichtung aufnehmenden Bereichs (203) wenigstens eine Öffnung (211) dahindurch definiert, um eine mechanische Befestigung darin aufzunehmen.

3. Installationselement (101) nach Anspruch 1 oder 2, das eine im Wesentlichen rechteckige Form aufweist.

4. Installationselement (101) nach einem der vorhergehenden Ansprüche, wobei der die Dichtung aufnehmende Bereich (203) eine im Wesentlichen rechteckige Rahmenform aufweist.

5. Installationselement (101) nach einem der vorhergehenden Ansprüche, hergestellt aus einem Kunststoffmaterial.

6. Installationselement (101) nach Anspruch 5, hergestellt unter Verwendung eines der Folgenden: eines Vakuumformverfahrens, eines Spritzgießverfahrens, eines Rotationsformverfahrens.

7. Installationselement (101) nach einem der vorhergehenden Ansprüche, wobei der Mittelbereich (207) mehrere Öffnungen (210) definiert, die jeweils konfiguriert sind, mehr als einen Versorgungsgegenstand (702) darin aufzunehmen.

8. Installationselement (101) nach einem der vorhergehenden Ansprüche, wobei der Versorgungsgegenstand (702) Folgendes ist: ein Kabel, ein Kabelkanal, eine Erdungsstange.

9. Installationselement (101) nach einem der vorhergehenden Ansprüche für: einen Schaltschrank, einen Telekommunikationsschrank.

10. Verfahren zum Installieren eines am Boden montierten Artikels von Städtmöblierung (103), wobei das Verfahren die folgenden Schritte umfasst:
Aufnehmen eines Installationselements (101) nach einem der Ansprüche 1 bis 9,
Positionieren des aufgenommenen Installationselements (101) an einer Bodeninstallationsstelle (501) und
Verwenden des positionierten Installationselements (101) als eine Vorlage zum Einrichten eines Stützbasisstandorts (502) für den am Boden montierten Artikel von Stadtmöblierung (103).

11. Verfahren nach Anspruch 10, die folgenden weiteren Schritte umfassend:
Graben eines Stützbasislochs (601) an dem Stützbasisstandort (502),
Positionieren des Installationselements (101) in dem gegrabenen Stützbasisloch (601) und
Verwenden des positionierten Installationselements (101) als eine Vorlage zum Einrichten eines Versorgungsgegenstandsstandorts (701) für den am Boden montierten Artikel von Stadtmöblierung (103).

12. Verfahren nach Anspruch 11, die folgenden weiteren Schritte umfassend:
Entfernen des positionierten Installationselements (101) aus dem gegrabenen Stützbasisloch (601),
Füllen des gegrabenen Stützbasislochs (601) mit Stützbasismaterial (801), um eine Stützbasis (901) für den am Boden montierten Artikel von Stadtmöblierung (103) auszubilden, und
Errichten des Installationselements (101) auf der Stützbasis (901).

13. Verfahren nach Anspruch 12, die folgenden weiteren Schritte umfassend:
Aufnehmen einer Gummidichtung (209) zur Verwendung mit dem Installationselement (101) und
Platzieren der aufgenommenen Gummidichtung (209) in dem die Dichtung aufnehmenden Bereich (203) des errichteten Installationselements (101).

14. Verfahren nach Anspruch 13, die folgenden weiteren Schritte umfassend:
Aufnehmen des am Boden montierten Artikels von Stadtmöblierung (103) und
Platzieren des aufgenommenen am Boden montierten Artikels von Stadtmöblierung (103) auf der Gummidichtung (209), platziert im die Dichtung aufnehmenden Bereich (203) des errichteten Installationselements (101).

## Revendications

1. Elément d'installation (101) pour une utilisation dans un procédé d'installation d'un article de mobilier urbain monté au sol (103), tel qu'une armoire, ledit élément d'installation (101) comprenant :
un côté inférieur (201) pour une localisation sur une base de support (401, 901) pour un article de mobilier urbain monté au sol (103), et
un côté supérieur (202) comprenant une région de réception de joint d'étanchéité (203) définie par une surface de base (204) depuis laquelle une paroi latérale intérieure (205) et une paroi latérale extérieure (206) s'étendent vers le haut, ladite région de réception de joint d'étanchéité (203) servant à recevoir un joint d'étanchéité en caoutchouc (209) à l'intérieur sur lequel les bords inférieurs de l'article de mobilier urbain monté au sol (103) peuvent être situés,
ledit élément d'installation (101) comprenant une région centrale (207) à l'intérieur de ladite paroi latérale intérieure (205) de ladite région de réception de joint d'étanchéité (203) et une bride de périmètre (208) à l'extérieur de ladite paroi latérale extérieure (206) de ladite région de réception de joint d'étanchéité (203)
ladite région centrale (207) définissant au moins une ouverture (210) au travers, ouverte sur ledit côté supérieur (202) et sur ledit côté inférieur (201), pour y recevoir un élément utilitaire (702),
**caractérisé en ce que**
ladite bride de périmètre (208) s'étend sensiblement dans le même plan que ladite surface de base (204) de ladite région de réception de joint d'étanchéité (203).

2. Elément d'installation (101) selon la revendication 1, dans lequel ladite surface de base (204) de ladite région de réception de joint d'étanchéité (203) définit au moins une ouverture (211) au travers pour y recevoir une fixation mécanique.

3. Elément d'installation (101) selon l'une ou l'autre de la revendication 1 et de la revendication 2, ayant une forme sensiblement rectangulaire.

4. Elément d'installation (101) selon l'une quelconque des revendications précédentes, dans lequel ladite région de réception de joint d'étanchéité (203) a une forme de cadre sensiblement rectangulaire.

5. Elément d'installation (101) selon l'une quelconque des revendications précédentes, fabriqué à partir d'un matériau en plastique.

6. Elément d'installation (101) selon la revendication 5, fabriqué à l'aide de l'un parmi : un procédé de formation sous vide, un procédé de moulage par injection, un procédé de moulage rotatif.

7. Elément d'installation (101) selon l'une quelconque des revendications précédentes, dans lequel ladite région centrale (207) définit une pluralité d'ouvertures (210) qui sont configurées chacune pour y recevoir plus d'un élément utilitaire (702).

8. Elément d'installation (101) selon l'une quelconque des revendications précédentes, dans lequel ledit élément utilitaire (702) est : un câble, un conduit de câbles, un piquet de terre.

9. Elément d'installation (101) selon l'une quelconque des revendications précédentes, pour : une armoire électrique, une armoire de télécommunications.

10. Méthode d'installation d'un article de mobilier urbain monté au sol (103), ladite méthode comprenant les étapes :
de réception d'un élément d'installation (101) selon l'une quelconque des revendications 1 à 9,
de positionnement dudit élément d'installation reçu (101) au niveau d'un site d'installation au sol (501), et
d'utilisation dudit élément d'installation positionné (101) en tant que gabarit pour établir une localisation de base de support (502) pour ledit article de mobilier urbain monté au sol (103).

11. Méthode selon la revendication 10, comprenant les étapes supplémentaires :
d'excavation d'un trou de base de support (601) au niveau de ladite localisation de base de support (502),
de positionnement dudit élément d'installation (101) dans le trou de base de support excavé (601), et
d'utilisation dudit élément d'installation positionné (101) en tant que gabarit pour établir une localisation d'élément utilitaire (701) pour ledit article de mobilier urbain monté au sol (103).

12. Méthode selon la revendication 11, comprenant les étapes supplémentaires :
d'enlèvement dudit élément d'installation positionné (101) dudit trou de base de support excavé (601),
de remplissage dudit trou de base de support excavé (601) avec un matériau de base de support (801) pour former une base de support (901) pour ledit article de mobilier urbain monté au sol (103), et
d'implantation dudit élément d'installation (101) sur ladite base de support (901).

13. Méthode selon la revendication 12, comprenant les étapes supplémentaires :
de réception d'un joint d'étanchéité en caoutchouc (209) pour une utilisation avec ledit élément d'installation (101), et
de localisation dudit joint d'étanchéité en caoutchouc reçu (209) au sein de ladite région de réception de joint d'étanchéité (203) dudit élément d'installation implanté (101).

14. Méthode selon la revendication 13, comprenant les étapes supplémentaires :
de réception dudit article de mobilier urbain monté au sol (103), et
de localisation dudit article de mobilier urbain monté au sol reçu (103) sur ledit joint d'étanchéité en caoutchouc (209) localisé avec ladite région de réception de joint d'étanchéité (203) dudit élément d'installation implanté (101).
